(19) Europäisches Patentamt / European Patent Office / Office européen des brevets

(11) **EP 1 918 343 A1**

(12) **EUROPEAN PATENT APPLICATION**

(43) Date of publication:
**07.05.2008 Bulletin 2008/19**

(51) Int Cl.:
*C09J 7/02* (2006.01)    *H01L 21/68* (2006.01)

(21) Application number: **07021321.0**

(22) Date of filing: **31.10.2007**

(84) Designated Contracting States:
**AT BE BG CH CY CZ DE DK EE ES FI FR GB GR HU IE IS IT LI LT LU LV MC MT NL PL PT RO SE SI SK TR**
Designated Extension States:
**AL BA HR MK RS**

(30) Priority: **06.11.2006 JP 2006299864**

(71) Applicant: **NITTO DENKO CORPORATION**
**Ibaraki-shi, Osaka 567-8680 (JP)**

(72) Inventors:
• **Asai, Fumiteru**
 **Ibaraki-shi**
 **Osaka 567-8680 (JP)**
• **Sasaki, Takatoshi**
 **Ibaraki-shi**
 **Osaka 567-8680 (JP)**

• **Shintani, Toshio**
 **Ibaraki-shi**
 **Osaka 567-8680 (JP)**
• **Takahashi, Tomokazu**
 **Ibaraki-shi**
 **Osaka 567-8680 (JP)**
• **Miki, Tsubasa**
 **Ibaraki-shi**
 **Osaka 567-8680 (JP)**
• **Yamamoto, Akiyoshi**
 **Ibaraki-shi**
 **Osaka 567-8680 (JP)**

(74) Representative: **Schmitz, Hans-Werner**
 **Hoefer & Partner**
 **Patentanwälte**
 **Pilgersheimer Strasse 20**
 **81543 München (DE)**

(54) **Adhesive sheet for water jet laser dicing**

(57) The present invention provides an adhesive sheet for water jet laser dicing, comprising an adhesive layer laminated on a base film which has a mean opening diameter of 5 μm to 30 μm. According to the adhesive sheet of the invention, a base film having a mean opening diameter of a certain size is used, thus ensuring better permeability to liquids originating in a liquid stream, and preventing the material that is being processed from being separated by the liquids from the adhesive sheet. In addition, the relatively low mean opening diameter makes it possible to control rippling on the surface of the base film and kept the surface flat, resulting in better adhesion to the material being processed and ensuring that the material being processed is secured during the dicing stage. The ability to improve the adhesion between the base film and the adhesive layer also makes it possible to prevent the separation of the adhesive form the base film and the adhesion of the adhesion on the material being processed when picked up after dicing.

Fig.1

EP 1 918 343 A1

**Description**

BACKGROUND OF THE INVENTION

1. Field of the Invention

The present invention relates to an adhesive sheet for water jet laser dicing, and more particularly relates to an adhesive sheet for water jet laser dicing used to fix a semiconductor wafer and/or a semiconductor-related material during dicing with a water jet laser.

2. Background Information

The conventional practice has been to use a rotary blade to cut semiconductor wafers, semiconductor-related materials and the like, and separate them into chips and IC parts. In this dicing step, the semiconductor wafer or the like is usually first affixed with an adhesive tape, for example, to fix it in place. After the semiconductor wafer or the like has been cut into chips, they are removed from the adhesive tape by a pick-up.

However, physical stress produced by the dicing blade can cause die fly-off in the chips and the like cut by this method, or cause cracking, chipping, and other such defects, which lowers the quality of the chips and the like, and also lowers the productivity of this cutting method. In particular, this problem has become more serious as there has been greater demand for even smaller and thinner electronic devices in recent years.

In view of this, a dicing method that makes use of a laser beam, and particularly a method for processing materials by cutting, perforating, welding, stamping, peeling, or the like using a laser beam guided by a liquid jet, has been proposed as an alternative to techniques for cutting semiconductor wafers and the like with a dicing blade (see WO95/32834, for example). With this method, the wafer or the like is merely exposed to a water jet from above, which prevents die fly-off and the like caused by the physical stress produced by a rotating blade.

Also, with a cutting method that makes use of this laser technique, the use of a water jet can be a problem in that it makes the chips or the like more susceptible to coming loose from the adhesive tape that fixes them, and in an effort to deal with this, an adhesive tape has been proposed that can be used preferably in water jet laser dicing (see Japanese Laid-Open Patent Application 2001-316648, for example).

SUMMARY OF THE INVENTION

An object of the present invention is to provide an adhesive sheet in which, during water jet laser dicing, better and more stable permeability to liquids originating in a liquid stream as well as better adhesion between the base film and adhesive layer can prevent the separation of adhesive from the base film and the adhesion of the adhesive to the materials being processed (i.e., workpiece) when picked up after dicing, and can also allow extremely thin semiconductor wafers or materials to be processed.

The present invention provides an adhesive sheet for water jet laser dicing, comprising an adhesive layer laminated on a base film which has a mean opening diameter of 5 μm to 30 μm.

According to the adhesive sheet for water jet laser dicing of the present invention, a base film having a mean opening diameter of a certain size is used, thus ensuring better permeability to liquids originating in a liquid stream, and preventing the material that is being processed from being separated by the liquids from the adhesive sheet. In addition, the relatively low mean opening diameter makes it possible to control rippling on the surface of the base film and kept the surface flat, resulting in better adhesion to the material being processed and ensuring that the material being processed is secured during the dicing step. The ability to improve the adhesion between the base film and the adhesive layer also makes it possible to prevent the separation of the adhesive form the base film and the adhesion of the adhesion on the material being processed when picked up after dicing.

BRIEF DESCRIPTION OF THE DRAWINGS

FIG. 1 is simplified plan view of the adhesive sheet of laser processing of the present invention.
FIG. 2 is simplified cross sectional view of the adhesive sheet of laser processing of the present invention explaining a method for measuring adhesive strength between the base film and the adhesive layer.

DETAILED DESCRIPTION OF THE PREFERRED EMBODIMENTS

The adhesive sheet for water jet laser dicing of the present invention mainly comprises a base film and an adhesive layer disposed on this base film. The phrase "adhesive sheet for water jet laser dicing" here refers to an adhesive sheet that is used in dicing with a laser beam guided by a liquid jet (usually a water jet), and with which the liquid used in this liquid jet during dicing, such as a liquid jet with at least a specific pressure, and the liquid that is applied directly or indirectly from the adhesive layer side can escape from one side of the adhesive sheet to the other side. The specific pressure here is usually about a few MPa or higher.

Examples of the base film include non-woven, woven and the like (i.e., mesh) made of a film or a fiber. Examples of the film include a synthetic resin, for example, polyolefins such as polyethylene, polypropylene (e.g., low-density polyethylene, liner low-density polyethylene, high-density polyethylene, drawn polypropylene, non-drawn polypropylene, ethylene-polypropylene copolymer, ethylene-vinyl acetate copolymer, ethylene-(meth)acrylic acid copolymer, ethylene-(meth)acrylic ester copolymer and the like), polyester, polyethylene terephthalate, polyurethane, EVA, polytetrafluoroethylene, polyvinyl chloride, polyvinylidene chloride, polyamide, acetal resin, polystyrene, polysulfone, polycarbonate, nylon, fluorocarbon polymer; rubber-containing polymer such as styrene-butadiene copolymer. Examples of the fiber include a polymer fiber such as PP, PVC, PE, PU, PS, PO, PET and the like; a synthetic fiber such as rayon, acetylcellulose and the like; a natural fiber such as cotton, silk, wool and the like; an inorganic fiber such as glass fiber, carbon fiber and the like. Among these, the base film is preferably formed of a polyolefin or includes a layer composed of a polyolefin. As a result, both adequate strength and expandability for laser dicing can be ensured for the adhesive sheet. These can be used single layer or multilayer of more than two layers. The fibers may be either monofilaments or multifilaments. Monofilaments are preferred in order to make the mean opening diameter of the base film more uniform described below.

The base film has at least one perforation (i.e. hole), or tow or more perforations. The perforation preferably pass through in the thickness direction, but numerous perforations may be joined, resulting in perforations that are linked in the thickness direction. In particular, the perforation of the base film is preferably the kind of opening obtained when the base film is composed of a mesh structure. The porosity of the base film is preferably no more than about 30%, and the mean opening diameter is preferably about 5 to 30 $\mu$m. As used here, the mean opening diameter means the diameter when the perforation is generally round, and means the length on one side when the perforation has a polygonal shape or the like. From another standpoint, the perforation size may suitable be, for example, about 10 $\mu$m$^2$ to 3.0 mm$^2$, preferably about 25 $\mu$m$^2$ or more, about 100 $\mu$m$^2$ or more, about 1000 $\mu$m$^2$ or more, about 0.1 mm$^2$ or more, and about 3.0 mm$^2$ or less, about 2.0 mm$^2$ or less, about 1.1 mm$^2$ or less, about 900 $\mu$m$^2$ or less. A porosity/mesh mean opening diameter that are too great will result in less area in contact with the adhesive, which will fail to ensure sufficient adhesion between the base film and the adhesive, and the adhesive may fill in the pore/mesh opening, which may compromise the evenness of the adhesive surface. This may result in gaps or the like in the interface between the adhesive sheet and the material being processed, which may result in poor dimensional precision during the laser process and, depending on the type of material being processed (such as glass or silicon wafer), "chipping" during the dicing process. On the other hand, if the porosity/mesh mean opening diameter are too low, it will be possible to ensure that the adhesive layer of the adhesive sheet will have a uniform surface roughness, but substantially no adhesive will fill in the pore/mesh opening, resulting in less of an anchor effect (wedging effect) and thus lower adhesive strength. Furthermore, water used during the water jet laser dicing step will not pass through the base film very well, resulting in problems such as scattering of the material being processed.

To make the base film into a mesh structure, for example, the fiber diameter is preferably about 10 to 150 $\mu$m, and even more preferably about 25 to 80 $\mu$m from the standpoint of liquid permeability.
The thickness of the base film is generally 10 to 400 $\mu$m, preferably 30 to 250 $\mu$m, for avoiding fracture or breaking of the sheet during processing the semiconductor wafer or the like as well as decreasing manufacturing cost.

The base film, e. g., the mesh film may be subjected to surface treatment, such as corona discharge treatment, flame treatment, plasma treatment, sputter etching treatment, undercoating (e.g., primer), fluorine treatment; or degreasing treatment using a chemical solution on the surface thereof on which the adhesive film is formed, for the enhancement of the adhesiveness to the adhesive film. Applying a primer is especially preferable.

The adhesive sheet of the present invention preferably has an elongation of over 100%, and more preferably 150%. This is because stretching the adhesive sheet makes it possible for the chips or the like to be easily picked up from the adhesive sheet after the dicing step.
Furthermore, the adhesive sheet preferably has a tensile strength of over 0.1 N/20 mm, more preferably over 0.3 N/20 mm. The reason for this is to avoid breaking and/or cutting the adhesive sheet itself.

The elongation and tensile strength can be measured, for example, with a tensile tester using a sample with a length of 5.0 cm and a width of 20 mm. The tensile speed during the test is 300 mm/minute at room temperature (according to ASTM D1000). The elongation can be calculated as follows.

$$\text{Elongation (\%) = (Fracture Length} - \text{Original Length)} \div \text{(Original Length)} \times 100$$

The tensile strength is a value at fracturing.

The adhesive layer comprises an adhesive coated on one side of the base film. This adhesive may be any type of pressure sensitive, heat-sensitive, photosensitive, but it is suitably a type that is cured by an energy radiation, because this allows the layer to be easily removed from the workpiece. The energy radiation used here can be radiation of various wavelengths, such as ultraviolet rays, visible light rays, or infrared rays, but since the laser beam used for dicing is one with an oscillation wavelength less than 400 nm, such as a third or fourth harmonic of a YAG laser with an oscillation wavelength of 355 nm or 266 nm, XeCl excimer laser with an oscillation wavelength of 308 nm, or KrF excimer laser with an oscillation wavelength of 248 nm, or one with an oscillation wavelength greater than 400 nm, such as a titanium sapphire laser with a wavelength near 750 to 800 nm, which allows light absorption in the UV band via a multi-photon absorption process, which allows cutting at a width of 20 $\mu$m or less by multi-photon absorption ablation, and which has a pulse width of 1 $e^{-9}$ second or less, it is preferable to use an adhesive that will not be cured by a irradiation with the laser beam of the dicing apparatus being used.

A known adhesive including (meth)acrylic polymers and rubber-based polymers can be used as the material that forms the adhesive layer, but a (meth)acrylic polymer is particularly preferable because even when a photosensitive adhesive is formed, it can be cured without adding any special monomer/oligomer component or the like for an energy radiation curing.

Examples of rubber-based polymers include natural rubbers, such as polyisoprene; and synthetic rubbers, such as styrene-butadiene rubber or a rubber based on polybutadiene, butadiene-acrylonitrile, chloroprene and the like.

Examples of a monomer component of (meth)acrylic polymers include alkyl acrylates and alkyl methacrylates having linear or branched alkyl groups with 30 or fewer carbons, and preferably 4 to 18 carbons, such as methyl, ethyl, n-propyl, isopropyl, n-butyl, t-butyl, isobutyl, pentyl, isopentyl, hexyl, cyclohexyl, heptyl, 2-ethylhexyl, octyl, isooctyl, nonyl, isononyl, decyl, isodecyl, undecyl, rauryl, tridecyl, tetradecyl, stearyl, octadecyl, and dodecyl. These alkyl (meth) acrylates can be used alone or as mixture of more than two components.

Examples of a monomer component other than the above monomers include carboxyl-containing monomer such as acrylic acid, methacrylic acid, carboxyethyl (meth)acrylate, carboxypentyl (meth)acrylate, itaconic acid, maleic acid, fumaric acid, and crotonic acid; acid anhydride monomer such as maleic anhydride, itaconic anhydride; hydroxyl group-containing monomer such as 2-hydroxyethyl (meth)acrylate, 2-hydroxypropyl (meth)acrylate, 4-hydroxybutyl (meth)acrylate, 6-hydroxyhexyl (meth)acrylate, 8-hydroxyoctyl (meth)acrylate, 10-hydroxydodecyl (meth)acrylate, 12-hydroxyrauryl (meth)acrylate, 4-hydroxymethyl cyclohexyl methyl(meth)acrylate; sulfonate-containing monomer such as styrenesulfonate, allylsulfonate, 2-(meth) acrylamide-2-methyl propanesulfonate, (meth)acrylamide propanesulfonate, sulfopropyl (meth)acrylate, (meth)acryloyl oxynaphthalenesulfonate; phosphate-containing monomer such as 2-hydroxyethyl acryloylphosphate; (meth)acrylamide; N-hydroxymethylamide (meth)acrylate; alkylamino alkylester (meth)acrylate such as dimethylamino ethylmethacrylate, t-butylamino ethylmethacrylate; N-vinylpyrrolidone; acryloyl morpholine; vinyl acetate; styrene; acrylonitrile and the like. These monomer components can be used alone or as mixture of more than two components.

Multifunctional monomers may be added as needed for the purpose of crosslinking (meth)acrylic polymer. Examples of the multifunctional monomer include 1,6-hexanediol di(meth)acrylate, polyethylene glycol di(meth)acrylate, polypropylene glycol di(meth)acrylate, neopentylglycol di(meth)acrylate, pentaerythritol di(meth)acrylate, trimethylolpropane tri(meth)acrylate, pentaerythritol tri(meth)acrylate, pentaerythritol tetra(meth)acrylate, dipentaerythritol monohydroxy penta(meth)acrylate, dipentaerythritol hexa(meth)acrylate, epoxy(meth)acrylate, polyester (meth)acrylate, urethane (meth)acrylate and the like. These multifunctional monomer components can be used alone or as mixture of more than two components. From the standpoint of adhesion characteristic and the like, the amount in which the multifunctional monomers are contained is preferably no more than 30 wt%, more preferably no more than 20 wt% of the total monomer component.

It is even more preferable to use a monomer and/or oligomer having an energy radiation curable functional group, such as a carbon-carbon double bond.

Examples of the monomer and/or oligomer include urethane (meth)acrylate, trimethylolpropane tri(meth)acrylate, pentaerythritol tri(meth)acrylate, pentaerythritol tetra(meth)acrylate, dipentaerythritol monohydroxy penta(meth)acrylate, dipentaerythritol hexa(meth)acrylate, 1,4-butylene glycol di(meth)acrylate and the like. These components can be used alone or as mixture of more than two components. There are no particular restrictions on the amount in which these are contained, but from the standpoint of adhesion characteristic, about 5 to 500 weight parts, or about 70 to 150 weight parts per 100 weight parts of the (meth)acrylic polymer or other base polymer of the adhesive is preferable.

It is preferable to use a photopolymerization initiator when a photosensitive adhesive is formed. Examples of the photopolymerization initiator include acetophenone compounds such as 4-(2-hydroxyethoxy) phenyl(2-hydroxy-2-

propyl) ketone, $\alpha$-hydroxy-$\alpha$,$\alpha$-methyl acetophenone, methoxy acetophenone, 2,2-dimethoxy-2-phenyl acetophenone, 2,2-diethoxy-acetophenone, 1-hydroxycyclohexyl phenyl ketone, 2-methyl-1-[4-(methyltio)phenyl]-2-morpholinoprophane-1; benzoine ether compounds such as benzoine ethyl ether, benzoine isopropyl ether, anisoin methyl ether; $\alpha$-ketol compounds such as 2-methyl-2-hydroxypropylphenon; ketal compounds such as benzyldimethyl keral; aromatic sulfonyl chloride compounds such as 2-naphthalene sulfonyl chloride; light-active oxime compounds such as 1-phenon-1,1-propanedione-2-(o-ethoxycarbonyl) oxime; benzophenone compounds such as benzophenone, benzoylbenzoate, 3,3'-dimethyl-4-methoxybenzophenone; thioxanthone compounds such as thioxanthone, 2-chlorothioxanthone, 2-methylthioxanthone, 2,4-dimethylthioxanthone, isopropylthioxanthone, 2,4-dichlorothioxanthone, 2,4-diethylthioxanthone, 2,4-diisopropylthioxanthone; camphor chinone; ketone halide; acyl phosphinoxide; acyl phosphonate and the like. These components can be used alone or as mixture of more than two components. The amount in which the photopolymerization initiators are contained, about 0.1 to 10 weight parts, or about 0.5 to 5 weight parts per 100 weight parts of the base polymer of the adhesive is preferable.

A crosslinking agent may also be added to raise the weight average molecular weight of the base polymer. Examples of the crosslinking agent include polyisocyanate compounds, epoxy compounds, aziridine compounds, melamine resins, urea resins, anhydrous compounds, polyamines, carboxyl group-containing polymers and the like. These can be used alone or as mixture of more than two compounds. When a crosslinking agent is used, it is generally preferable for it to be used in an amount of about 0.01 to 5 weight parts per 100 weight parts base polymer so that the peeling-off adhesion strength will not decrease too much.

In addition to the above components, the adhesive may optionally comprise any conventional additive such as tackifiers, antioxidants, fillers, pigments and the like.

The acrylic polymer can be prepared, for example, by applying a known method such as solution polymerization, emulsion polymerization, mass polymerization, suspension polymerization to one or more kinds of monomer or a mixture thereof. Among these, solution polymerization is preferable. Examples of solvents that can be used include ethyl acetate, toluene and other such polar solvents. The solution concentration is usually about 20 to 80 wt%.

A polymerization initiator may be used in the preparation of the polymer. Examples of the polymerization initiator include peroxides such as hydrogen peroxide, benzoyl peroxide, t-butyl peroxide, and the like. One may be used by itself, or it may be combined with a reducing agent and used as a redox type of polymerization initiator. Examples of the reducing agent include ionic salts such as salts of iron, copper, cobalt, sulfite, bisulfite; amines such as triethanol amine; reducing sugar such as aldose, ketose and the like. Also, azo compounds such as 2,2'-azobis-2-methylpropioamidine salt, 2,2'-azobis-2,4-dimethylvaleronitrile, 2,2'-azobis-N,N'-dimethyleneisobutylamidine salt, 2,2'-azobisisobutyronitrile, 2,2'-azobis-2-methyl-N-(2-hydroxyethyl) propionamide may be used. These can be used alone or as mixture of more than two components.

The reaction temperature is usually about 50 to 85°C, and the reaction time about 1 to 8 hours.

From the standpoint of preventing fouling of the workpiece and the like, it is preferable for the acrylic polymer to have a low content of low-molecular weight substances, and for the acrylic polymer to have a number average molecular weight of at least 300,000, particularly at a rage of about 800,000 to 3,000,000.

The thickness of the adhesive layer can be suitably adjusted within a range in which the layer will not come off the workpiece, but from the standpoints of ensuring adequate adhesive strength, preventing undesirable adhesive residue from remaining on the back of the semiconductor wafer or the like after the wafer or the like has been removed from the tape, and allowing water to pass through easily by cutting the adhesive layer, the thickness is usually about 1 to 30 $\mu$m, about 1 to 20 $\mu$m, about 3 to 30 $\mu$m, preferably about 3 to 20 $\mu$m. This minimizes resonance of the adhesive layer caused by vibration attributable to the liquid jet or irradiation with the laser beam during dicing, allows the oscillation amplitude to be suppressed, and prevents cracking, chipping, and the like of the chips. It also allows the workpiece to be securely fixed during dicing.

As discussed below, the adhesive layer may include at least one perforation as the base film does. This perforation can be formed by any of the methods discussed below for the base film. It is preferable, though, to form this perforation simultaneously with the perforation in the base film because they will then go all the way through from the base film to the adhesive layer, that is, the perforation in the base film overlap with the perforation in the adhesive layer.

The adhesive sheet of the present invention can be formed by a tape manufacturing method known in this field of technology. For example, the base film is provided first. The adhesive, then, can be laminated onto the base film. The base film may be coated directly, or a transfer coating process may be employed in which a process material coated with a release agent is coated with the adhesive and dried, after which the adhesive is laminated to the base film, or the adhesive may be laminated in a rolling mill on the base film. These coating process can be performed by any existing coating method, for example, reverse roll coating, gravure coating, curtain spray coating, die coating, extrusion and other industrially applied coating methods may be used. The base film that is prepared may have perforations already in the base film, or the perforations may be formed after the base film has been coated with the adhesive.

The adhesive sheet of the present invention preferably has an average arithmetic roughness Ra of about 1.0 $\mu$m or less, about 0.8 $\mu$m or less, and more preferably about 0.6 $\mu$m or less. This allows to ensure sufficient adhesion between the base film and the adhesive layer as well as the adhesive layer and the workpeice.

The adhesive sheet of the present invention has an adhesive strength of at least 1.5 N/20 mm, preferably at least 3 N/20 mm, and less than 10 N/20 mm, preferably less than 8 N/20 mm. In other words, along with changes in dicing technology to technology involving the use of a water jet laser, the critical significance of the adhesive strength of an adhesive sheet used for dicing is also changing, and as a result, good adhesion with the wafer or the like during dicing can be ensure even at a weaker adhesive strength, and chips or parts can be prevented from coming loose from the adhesive tape. In addition, a reduction in the initial adhesive strength allows chipping and other such defects to chips, IC parts, and the like during pick-up to reduce. In particular, in the case of a photosensitive adhesive, the adhesive strength of the adhesive after irradiation can be effectively, quickly, and easily reduced. The adhesive strength after irradiation is preferably less than 0.2 N/20 mm, more preferably less than 0.18 N/20 mm.

Here, an adhesive strength is the value which is measured on an Si-mirror wafer under the conditions of 23 ± 3 ˚C, 180˚ peeling angle and a peeling speed of 300 mm/min (according to ASTM D1000).

Examples of the adhesive sheet for water jet laser dicing of the present invention will now be described in detail.

(Preparation of Adhesive)

60 weight parts methyl acrylate, 35 weight parts 2-ethylhexyl acrylate, and 5 weight parts of acrylic acid were copolymerized by a standard method in ethyl acetate to obtain a solution containing an acrylic copolymer with a weight average molecular weight of 700,000.

To this solution were added 100 weight parts UV-curing oligomer (viscosity of 10 Pa·sec at 25 ˚C) that was obtained by reaction of pentaerythritol triacrylate and diisocyanate, 3 weight parts photopolymerization initiator (trade name "Irgacure 651," made by Ciba Specialty Chemicals), and 2 weight parts polyisocyanate compound (trade name "Coronate L," made by Nippon Polyurethane Industry), which gave a UV-curing acrylic adhesive solution.

Example and Comparative Example

Adhesive sheets for laser dicing were prepared by applying adhesive, produced in the manner described above, to thicknesses of 5 $\mu$m, 15 $\mu$m, 30 $\mu$m, and 50 $\mu$m, on base films made by mesh films having a mean thickness of 45 $\mu$m, respectively. The base films ware composed of 20 $\mu$m in fiber diameter polyethylene terephthalate having a mean mesh opening diameter of 3 $\mu$m, 5 $\mu$m, 30 $\mu$m (opening area 30%), 50 $\mu$m (opening area 55%), and 100 $\mu$m (opening area 85%), respectively.

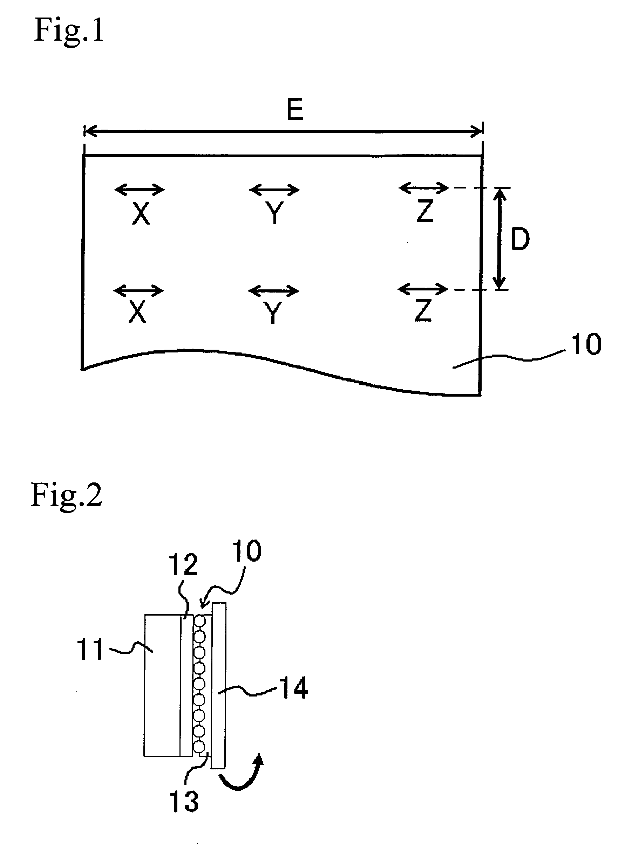

An average arithmetic roughness Ra was measured using the adhesive sheets produced in the example and comparative example. A measuring apparatus P-15 made by tencor, which was for measuring the step height, roughness and surface contour, measured was used. The adhesive sheets was measured a total of 30 points surface roughness, which were 3 points (X,Y and Z) in a width direction (for example, Width E = 1400 mm), and 10 points in length direction (for example, Distance D = 10 m) on the adhesive sheets, as shown in Fig. 1, respectively, for obtaining its mean value. This mean value is an average arithmetic roughness Ra. Each point was measured throughout the length of 50 mm on the surface side of the adhesive layer.

(Adhesion Between Base Film and Adhesive Layer)

As shown in Fig. 2, an SUS substrate was used as a substrate 11 to hold the tape, and double-sided tape 12 made by Nitto Denko was placed between the substrate 11 and the adhesive sheet 10.

Nitto Denko BT-315 tape 14 was laminated to the adhesive layer 13 side of the adhesive sheet 10, and the "adhesive strength" was the value measured when the Nitto Denko BT-315 tape 14 was pulled in the direction indicated by the arrow at an angle of 180˚ and a rate of 300 mm/min using a tension tester as stipulated in JIS B7721.

At measuring the adhesive strength, if the adhesive layer did not separate from the base film, the adhesive strength between the adhesive layer and base film was rated as being greater than the value when the layer was separated.

(Evaluation)

Silicon wafers were diced using the adhesive sheets obtained in the example and comparative example, and the water permeability and processing precision (chip fly-off and chipping) were determined during processing for comprehensive evaluation according to the following conditions.

Laser wavelength: 1064 nm,
Dicing speed: 50 mm/s,

Laser diameter: 50 μm,
Water jet pressure: 40 MPa,
Chip size: 1 mm × 1 mm,
Wafer size: 13.7 cm (5 inch),
Wafer thickness: 150 μm.
No water permeability was rated ×, partial permeability was rated Δ, and water permeability was rated O.

For the processing precision, 50% or greater chip fly-off and chipping was rated x, less than 50% was rated as Δ, and the absence of chip fly-off and chipping was rated O.

Comprehensive evaluation was based on water permeability and processing precision, but any pick up defects were indicated by an asterisk.

Table 1

| Opening Diameter | Adhesive layer Thickness (μm) | Average Roughness Ra (μm) | Adhesive Strength (N/ 20mm) | Water Permeability | Processing Precision | Comprehensive Evaluation |
|---|---|---|---|---|---|---|
| 3μm | 5 | 0.3 3 | 6.5 | Δ | × | × |
| | 20 | 0.2 | 6.7 | × | × | × |
| | 30 | 0.4 | 8.3 | × | × | × |
| | 50 | 0.3 | 8.4 | × | × | × |
| 5μm | 5 | 0.4 | 9.5 | O | O | O |
| | 20 | 0.5 | 13.4 or more | O | O | O |
| | 30 | 0.3 | 13.5 or more | Δ | Δ | Δ |
| | 50 | 0.4 | 13.2 or more | × | × | × |
| 30μm | 5 | 1.2 | 13.7 or more | O | O | O |
| | 20 | 0.9 | 14.0 or more | O | O | O |
| | 30 | 0.9 | 13.4 or more | O | O | O |
| | 50 | 0.8 | 14.1 or more | Δ | Δ | Δ |
| 50μm | 5 | 1.4 | 13.2 or more | O | O | O |
| | 20 | 0.8 | 13.8 or more | O | O | O |
| | 30 | 0.7 | 13.4 or more | O | O | O |
| | 50 | 0.8 | 13.6 or more | Δ | Δ | Δ * |
| 100μm | 5 | 1.5 | 7.4 | O | O | Δ * |
| | 20 | 1.2 | 8.3 | O | O | Δ * |
| | 30 | 1.3 | 7.2 | O | O | Δ * |
| | 50 | 1.4 | 8.8 | Δ | Δ | Δ * |

Table 1 shows that too great of a porosity/mesh mean opening diameter resulted in less contact area with the adhesive, the inability to ensure enough adhesion between the base film and adhesive, and the inability to ensure a smooth adhesive surface because the pores/mesh openings were filled in by the adhesive. As a result, gaps and the like were also formed in the interface between the adhesive sheet and the material being processed, resulting in poor laser processing precision and chipping during the dicing process.

When the porosity/mesh mean opening diameter were too low, it was possible to ensure that the adhesive layer of the adhesive sheet had a uniform surface roughness, but substantially no adhesive filled in the pores/mesh openings, resulting in less of an anchor effect (wedging effect) and thus lower adhesive strength. Furthermore, the water used during the water jet laser dicing stage did not permeate the base film very well, resulting in problems such as scattering of the material being processed.

On the other hand, when the base film had a mean opening diameter within the prescribed range, both the surface roughness and adhesion were favorable, allowing both chip fly-off and chipping to be controlled. It was confirmed in particular that the water originating in the water stream readily drained from the adhesive sheet, yet it was possible to ensure sufficient adhesion between the adhesive and chips and that chip fly-off was less likely to occur.

The adhesive sheet for water jet laser dicing of the present invention can be utilized in a wide range of applications in which a material is diced with a laser beam guided by a liquid jet, that is, it can be applied not only to semiconductor-related materials and the like (such as semiconductor wafers, BGA packages, printed wiring boards, ceramic boards, glass member for liquid crystal devices, sheet materials, circuit boards, glass substrates, ceramics substrates, metal substrates, light-emitting and light-receiving element substrates for semiconductor laser, MEMES substrates, semiconductor packages), but to all kinds of materials.

This application claims priority to Japanese Patent Application No. 2006-299864. The entire disclosure of Japanese Patent Application No. 2006-299864 is hereby incorporated herein by reference.

While only selected embodiments have been chosen to illustrate the present invention, it will be apparent to those skilled in the art from this disclosure that various changes and modifications can be made herein without departing from the scope of the invention as defined in the appended claims. Furthermore, the foregoing descriptions of the embodiments according to the present invention are provided for illustration only, and not for the purpose of limiting the invention as defined by the appended claims and their equivalents. Thus, the scope of the invention is not limited to the disclosed embodiments.

**Claims**

1. An adhesive sheet for water jet laser dicing, comprising an adhesive layer laminated on a base film which has a mean opening diameter of 5 $\mu$m to 30 $\mu$m.

2. The adhesive sheet according to Claim 1, wherein the base film is a mesh film.

3. The adhesive sheet according to Claim 1, wherein the base film made of a fiber comprising a monofilament or multifilament of 10 $\mu$m to 200 $\mu$m in fiber diameter.

4. The adhesive sheet according to Claim 1, wherein the adhesive layer has a thickness of 1 $\mu$m to 30 $\mu$m.

Fig.1

Fig.2

**European Patent Office**

## EUROPEAN SEARCH REPORT

Application Number

EP 07 02 1321

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | EP 1 270 694 A (NITTO DENKO CORP [JP]) 2 January 2003 (2003-01-02) * paragraphs [0013] - [0015], [0021] - [0025]; claims; table 1 * ----- | 1-4 | INV. C09J7/02 H01L21/68 |
| P,X | EP 1 767 606 A (LINTEC CORP [JP]) 28 March 2007 (2007-03-28) * paragraphs [0028] - [0041]; claim 1; example 1 * ----- | 1-4 | |
| X | EP 0 560 072 A (NITTO DENKO CORP [JP]) 15 September 1993 (1993-09-15) * column 4, lines 28-44; claims * * column 9, lines 23-46; examples * ----- | 1-4 | |
| X | EP 1 714 730 A (NITTO DENKO CORP [JP]) 25 October 2006 (2006-10-25) * paragraphs [0001], [0081], [0116], [0145]; claims; figures 2,4; example 1 * ----- | 1-4 | |
| X | DATABASE WPI Week 200014 Derwent Publications Ltd., London, GB; AN 2000-156897 XP002468422 & JP 2000 017240 A (NITTO DENKO CORP) 18 January 2000 (2000-01-18) * abstract * ----- | 1-4 | TECHNICAL FIELDS SEARCHED (IPC) C09J H01L |

The present search report has been drawn up for all claims

| Place of search | Date of completion of the search | Examiner |
|---|---|---|
| Munich | 11 February 2008 | Frison, Céline |

EPO FORM 1503 03.82 (P04C01)

## ANNEX TO THE EUROPEAN SEARCH REPORT
## ON EUROPEAN PATENT APPLICATION NO.

EP 07 02 1321

This annex lists the patent family members relating to the patent documents cited in the above-mentioned European search report.
The members are as contained in the European Patent Office EDP file on
The European Patent Office is in no way liable for these particulars which are merely given for the purpose of information.

11-02-2008

| Patent document cited in search report | | Publication date | Patent family member(s) | | Publication date |
|---|---|---|---|---|---|
| EP 1270694 | A | 02-01-2003 | DE<br>WO<br>US | 60031448 T2<br>0151580 A1<br>6890617 B1 | 01-02-2007<br>19-07-2001<br>10-05-2005 |
| EP 1767606 | A | 28-03-2007 | AU<br>CA<br>CN<br>WO<br>KR<br>US | 2005254828 A1<br>2571510 A1<br>1973013 A<br>2005123860 A1<br>20070024725 A<br>2007227653 A1 | 29-12-2005<br>29-12-2005<br>30-05-2007<br>29-12-2005<br>02-03-2007<br>04-10-2007 |
| EP 0560072 | A | 15-09-1993 | US | 5438223 A | 01-08-1995 |
| EP 1714730 | A | 25-10-2006 | WO<br>KR<br>US | 2005063435 A1<br>20060126479 A<br>2007181543 A1 | 14-07-2005<br>07-12-2006<br>09-08-2007 |
| JP 2000017240 | A | 18-01-2000 | NONE | | |

EPO FORM P0459

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 9532834 A
- JP 2001316648 A
- JP 2006299864 A